# EUROPEAN PATENT APPLICATION

(11) **EP 1 978 405 A1**
(43) Date of publication of application: **08.10.2008**
(21) Application number: 08153958.7
(22) Date of filing: 02.04.2008
(51) Int. Cl.: G03F 1/14

(54) **Pellicle and method for preparing the same**

(30) Priority: 04.04.2007 JP 2007098614; 21.03.2008 JP 2008074450
(71) Applicant: Shin-Etsu Chemical Co., Ltd., Tokyo (JP)
(72) Inventor: Shirasaki, Toru, Gunma-ken (JP)
(74) Representative: Peaucelle, Chantal

(57) **Abstract**

The present invention aims at reducing the thickness of a pellicle membrane while providing a strong pellicle membrane The method for manufacturing a pellicle of the present invention the steps of forming on a base plate a pellicle membrane comprising a fluorocarbon resin; peeling the membrane off the base plate; and heating the pellicle membrane. The heating temperature is preferably lower than the glass transition temperature of the pellicle membrane The pellicle membrane has a tensile strength not smaller than 38.25 MPa (390 kgf/cm²).

## Description

### BACKGROUND OF THE INVENTION

### 1. Field of the Invention

The present invention relates to a pellicle used as a dust-proof protection for photomasks employed in the manufacture of semiconductor devices, liquid crystal displays and the like, and relates to a method for preparing such a pellicle.

### 2. Description of the Related Art

Conventionally the manufacture of semiconductor devices such as LSI and ultta-LSI devices. or liquid crystal display panels and the like, has involved employing procedures such as lithography for the patterning of semiconductor wafers or liquid crystal base plates through irradiation of light. In lithography, a photomask is used as an original plate lor patterning, such that the pattern on the photomask is replicated to a wafer or a liquid crystal substrate.

However, lithography is problematic in that any dust adhering to the photomask absorbs and reflects light, which deforms and roughens the edges of the transferred patterning, thereby detracting from dimensions, quality and appearance, and impairing the performance of the semiconductor device and/or liquid crystal display pane while reducing the manufacturing yield thereof.

Thus, these operations are ordinarily carried out in clean rooms. However, preserving at all times photomasks in good conditions in such clean rooms is difficult and hence a pellicle for dust-proof protection is adhered to the surface of the photomask. The advantage of the pellicle is that dust does not attach directly to the surface of the photomask, but become adhered to the pellicle membrane, so that during lithography, focus is in accord with the pattern of the photomask and hence dust on the pellicle does not affect transfer on account of defocus.

The pellicle is made up of a pellicle frame comprising aluminum, stainless steel, polyethylene or the like, a transparent pellicle membrane adhered on the upper surface of the pellicle frame, comprising nitrocellulose, cellulose acetate or the like having good light transmissivity, an adhesive layer coated on the lower surface of the pellicle frame, and a release layer (separator) adhered on the adhesive layer, The adhesive bonding between the pellicle frame and pellicle membrane is carried out by coating a good solvent for the pellicle membrane material and then air-drying the solvent (Japanese Patent Application Laid-open No. S58-219023) or using an adhesive agent such as an acrylic resin, epoxy resin or the like (US Patent No. 4861402, Japanese Patent Examined Application Publication No S63-27707, Japanese Unexamined Patent Application Laid-open No H07-168345)

As a result of ever higher resolutions required in recent years in exposure devices for semiconductor manufacturing, the employed light sources are gradually shifting to ever shorter wavelengths in order to realize such resolutions. Specifically, there has been a shift towards g-line (436 nm), i-line (365 nm). KrF excimer lasers (248 nm) in ultraviolet light while ArF excimer lasers (193 nm) have begun to be used recently

Light energy is substantial at such short wavelengths, and hence it has been difficult to ensure sufficient light resistance in conventional cellulose-based membrane materials. Since the inception of KrF excimer lasers, therefore, transparent fluorocarbon resins have come to be used as membrane materials.

The use of immersion exposure devices employing an ArF excimer laser for even finer processing has begun to be studied in recent years. A higher NA (numerical aperture) can be realized by filling with a liquid the gap between the objective lens of the exposure device and the silicon wafer, which as a result allows achieving higher resolutions (International Patent Publication No. WO99/49504). Exposure devices having thus a higher NA afford a larger oblique incidence angle at portions around the light passing through the pellicle.

Pellicle transmissivity is set ordinarily so as to yield maximum transmissivity for vertically incident light. A phenomenon is observed herein whereby transmissivity decreases as the incidence angle increases Such decrease in transmissivity becomes more conspicuous as the thickness of the pellicle increases. Thinner pellicle membranes are being studied thus with a view to achieving higher transmissivities also for obliquely incident light.

A thinner pellicle membrane, however, means a less strong membrane, which is problematic. When foreign matter becomes adhered to the pellicle membrane, after attachment of the pellicle to the photomask, such foreign matter is ordinarily blown off through air blowing However, there is a problem that such a blowing operation increases the likelihood that a thinner and hence weaker pellicle membrane may be damaged or ruptured by air blowing.

### BRIEF SUMMARY OF THE INVENTION

In the light of the above, it is an object of the present invention to reduce the thickness of a pellicle membrane while providing a strong pellicle membrane.

The method for manufacturing a pellicle of the present invention comprises the steps of forming, on a base plate a pellicle membrane comprising a fluorocarbon resin; peeling the membrane off the base plate: and heating the pellicle membrane. The heating temperature is preferably lower than the glass transition temperature of the pellicle membrane,

In the pellicle of the present invention, the pellicle membrane has a tensile strength no smaller than 38.25 MPa (390 kgf/cm²)

By forming a pellicle membrane on a membrane-forming base plate, removing the pellicle membrane from the base plate, and heating the pellicle membrane at a temperature lower than the glass transition temperature of the material that forms the pellicle membrane, the present invention succeeds in increasing pellicle membrane strength, affording a pellicle both thin and highly strong.

### DETAILED DESCRIPTION OF THE INVENTION

In order to overcome the above drawbacks, the inventor found that membrane strength is enhanced by heating the pellicle membrane, after peeling thereof from the base plate, at a temperature that is lower than the glass transition temperature of the fluorocarbon resin used as the material of the pellicle membrane, in the pellicle manufacturing process, The inventor found also that a pellicle manufactured in accordance with a pellicle manufacturing process complemented with a pellicle membrane heating operation succeeded in reducing the frequency of or preventing altogether, the occurrence of the above-described problems associated with conventional technology.

The invention is explained in detail below.

The pellicle is ordinarily manufactured in accordance with the following process.

A solution having dissolved therein the resin comprised by the pellicle membrane is dripped onto a smooth-surface base plate, to form a homogeneous liquid membrane The liquid membrane is dried and then the resin membrane alone is peeled from the base plate. off the area occupied only by the resin membrane. The peeled pellicle membrane is affixed to an aluminum frame coated with an adhesive, binding agent or the like. The unwanted membrane outside the frame is cut out and removed to yield a finished pellicle

Achieving thinner pellicle membranes has been studied in recent years in high NA-compliant pellicles, with a view to obtaining high transmissivity over a wide range of light-beam incidence angles. Herein thinner pellicle membranes are obtained by lowering the concentration of the solution coated on the base plate, or by modifying conditions such as revolutions or the like during manufacture of a homogeneous liquid membrane with a spin coater

As described above, however, the mechanical strength of the pellicle membrane decreases as the membrane becomes thinner. In consequence, the pellicle membrane may suffer damage when stressed, for instance during affixing of the pellicle membrane to the frame, during affixing of the pellicle to the photomask, or when the pellicle is air-blown.

When the pellicle membrane is damaged, transmissivity decreases in the affected portion which results in uneven exposure The membrane may also break when such damage is extensive. If the pellicle breaks when affixed to the photomask, foreign matter may get into the pellicle, which is a very serious problem.

In the present invention, as described above, the pellicle membrane is heated after being peeled from the base plate, with a view to increasing membrane strength, Although the pellicle membrane can be heated immediately after being peeled from the base plate or after excision of unwanted membrane affixed to the pellicle frame, the membrane is heated preferably after being peeled from the base plate but before bonding to the frame, since heating of the membrane alone is simpler

As regards the heating temperature, higher temperatures enhance more effectively membrane strength, while the time required for the thermal treatment becomes also shorter at higher temperatures, Heating the pellicle membrane at a temperature beyond the glass transition temperature, however, is problematic in that, although membrane strength is enhanced vis-à-vis carrying out no heating the afforded membrane strength is lower than that achieved through heating at a temperature not exceeding the glass transition temperature.

Therefore, the heating temperature of the pellicle membrane is preferably lower than the glass transition temperature of the resin used in the pellicle membrane

A fluorocarbon resin is used in the pellicle membrane, in particular in pellicles used for ArF lithography. The glass transition temperature of such a resin depends on the molecular structure of the resin. Examples of the fluorocarbon resin used in ArF lithography include, for instance, a perfluoroether polymer having an annular structure (product name, Cytop CTX-S, Asahi Glass Co.). or a copolymer of tetrafluoroethylene and a fluorine-containing monomer having an annular perfluoroether group (product name, Teflon AF 1600, Du Pont). The former has a glass transition temperature of about 108°C and the latter of about 160°C. When using for instance CTX-S in the pellicle membrane material, the greatest membrane strength enhancement effect is achieved by heating the pellicle membrane at a temperature not exceeding 108°C, for instance at 100°C.

As regards heating duration, longer heating does enhance membrane strength, but the effect levels off at a certain heating duration. Therefore, it is preferable to determine beforehand the time that elapses until the effect levels off and during actual operation, heat the pellicle membrane over the ascertained duration. The pellicle membrane after peeling off the base plate is heated preferably in the range 60 °C to the glass transition temperature of the resin used in the pellicle membrane for at least 30 minutes.

A heating device such as a clean oven, IR lamp, hot plate or the like can be used for heating the pellicle membrane, When manutacturing the pellicle in a clean room, the use of an open-type heating device in the clean room places a burden on the temperature control of the clean room, and hence there is preferably used a heating device, such as a clean oven or the like, that enables high-temperature closed-space heating.

### EXAMPLES

Examples of the present invention are explained next.

### Example 1

A 3% solution of Cytop CTX-S (product name. Asahi Glass Co.) dissolved in perfluorotributylamine was dripped onto a silicone wafer, and was spread thereon by rotating the wafer at 900 rpm by spin coating. The solution was then made into a homogenous membrane through drying for 30 minutes at room temperature, followed by drying at 180°C. To the membrane there was attached an aluminum framework coated with an adhesive agent, and then the membrane was peeled to yield a pellicle membrane.

The pellicle membrane was placed in a clean oven. The temperature was raised to 100°C over 30 minutes and was kept thereafter at 100°C for one hour, after which oven heating was discontinued. The pellicle membrane was removed once the oven temperature had dropped to room temperature.

A membrane adhesive agent was coated on the top face of a frame made of aluminum having undergone a surface anodizing treatment (outer dimensions: 149 mm x 122 mm x 5 8 mm), while a photomask bonding agent was coated onto the underside. Thereafter, the thermally treated pellicle membrane was affixed to the membrane adhesive agent side of the frame, and the membrane on the outer periphery of the frame was cut out to finish thereby a pellicle. The finished pellicle had a measured thickness of 277 nm

The pellicle membrane was tested for tensile strength, The pellicle membrane was cut into a 25 mm x 50 mm strip, the two long sides of the strip were gripped by a clip, and the pellicle membrane was stretched by 25 mm. The stretching rate was 200 mm/minute. The stress exerted on the pellicle membrane was recorded, and the yield strength was calculated on the basis of the relationship between stress and membrane elongation. The yield strength in Example 1 was of about 39 23 MPa (400 kgf/cm²).

The pellicle membrane was also subjected to an air blow test in the air blow test, a nozzle having an inner diameter of 1 mm and equipped with a 0.2 µm filter was made to abut the pellicle perpendicularly Blowing lasted 10 seconds with an air pressure of 160 kPa (1.63 kgf/cm²) before the filter (primary pressure). Blowing began with a distance of 10 mm between the nozzle tip and the pellicle membrane. After blowing, the pellicle membrane was checked for presence or absence of damage. If no damage was observed, the distance was shortened to 9 mm, 8 mm and so forth. The test ended at the distance where the pellicle membrane suffered damage.

In Example 1 the pellicle membrane exhibited no damage down to a distance of 5 mm, with damage occurring at 4 mm. The lesser propensity to damage, vis-à-vis Comparative Example 1, was indicative of enhanced membrane strength Table 1 summarizes membrane strength results, and Table 2 air blow test results, for the examples and comparative examples.

### Example 2

A 3% solution of Cytop CTX-S (product name, Asahi Glass Co,) dissolved in perfluorotributylamine was dripped onto a silicone water, and was spread thereon by rotating the water at 900 rpm by spin coating. The solution was then made into a homogenous membrane through drying tor 30 minutes at room temperature, followed by drying at 180°C. To the membrane there was attached an aluminum framework coated with an adhesive agent, and then the membrane was peeled to yield a pellicle membrane

The pellicle membrane was placed in a clean oven. The temperature was raised to 60°C over 30 minutes and was kept thereafter at 60°C for one hour, after which oven heating was discontinued. The pellicle membrane was removed once the oven temperature had dropped to room temperature.

A membrane adhesive agent was coated on the top face of a frame made of aluminum having undergone a surface anodizing treatment (outer dimensions: 149 mm × 122 mm × 5.8 mm), while a photomask bonding agent was coated onto the underside. Thereafter, the thermally treated pellicle membrane was affixed to the membrane adhesive agent side of the frame, and the membrane on the outer periphery of the frame was cut out to finish thereby a pellicle. The finished pellicle had a measured thickness of 277 nm.

The pellicle membrane was tested for tensile strength. The test method was the same as in Example 1. The yield strength was of about 38.25 MPa (390 kgf/ cm²).

The pellicle membrane was also subjected to an air blow test. The test method was the same as in Example 1. In Example 2 the pellicle membrane exhibited no damage down to a distance of 7 mm, with damage occurring at 6 mm. The lesser propensity to damage, Vis-à-vis Comparative Example 1, was indicative of enhanced membrane strength. However, membrane strength was not enhanced as much as in Example 1, since the heating temperature was lower that that of Example 1.

### Example 3

A 3% solution of Cytop CTX-S (product name. Asahi Glass Co.) dissolved in perfluorotributylamine was dripped onto a silicone wafer, and was spread thereon by rotating the wafer at 900 rpm by spin coating. The solution was then made into a homogenous membrane through drying for 30 minutes at room temperature, followed by drying at 180°C. To the membrane there was attached an aluminum framework coated with an adhesive agent, and then the membrane was peeled to yield a pellicle membrane

The pellicle membrane was placed in a clean oven. The temperature was raised to 120°C over 30 minutes and was kept thereafter at 120°C for one hour, after which oven heating was discontinued. The pellicle membrane was removed once the oven temperature had dropped to room temperature.

A membrane adhesive agent was coated on the top face of a frame made of aluminum having undergone a surface anodizing treatment (outer dimensions: 149 mm × 122 mm × 5.8 mm), while a photomask bonding agent was coated onto the underside. Thereafter, the thermally treated pellicle membrane was affixed to the membrane adhesive agent side of the frame, and the membrane on the outer periphery of the frame was cut out 10 finish thereby a pellicle. The finished pellicle had a measured thickness of 277 nm.

The pellicle membrane was tested for tensile strength. The test method was the same as in Example 1. The yield strength was of about 37.76 MPa (385 kgf/cm²).

The pellicle membrane was also subjected to an air blow test. The air blow test was identical to that of Example 1. In Example 3 the pellicle membrane exhibited no damage down to a distance of 8 mm, with damage occurring at 7 mm, The lesser propensity to damage, vis-à-vis Comparative Example 1, was indicative of enhanced membrane strength. However, membrane strength was not enhanced as much as in Example 1 and Example 2, since the heating temperature was higher than the glass transition temperature of the resin.

### Comparative Example 1

A 3% solution of Cytop CTX-S (product name, Asahi Glass Co.) dissolved in perfluorotributylamine was dipped onto a silicone wafer, and was spread thereon by rotating the wafer at 900 rpm by spin coating. The solution was then made into a homogenous membrane through drying for 30 minutes at room temperature, followed by drying at 180°C. To the membrane there was attached an aluminum framework coated with an adhesive agent, and then the membrane was pealed to yield a pellicle membrane.

A membrane adhesive agent was coated on the top face of a frame made of aluminum having undergone a surface anodizing treatment (outer dimensions, 149 mm × 122 mm × 5.8 mm), while a photomask bonding agent was coated onto the underside. Thereafter, the thermally treated pellicle membrane was affixed to the membrane adhesive agent side of the frame, and the membrane on the outer periphery of the frame was cut out to finish thereby a pellicle. The finished pellicle had a measured thickness of 277 nm.

The pellicle membrane was tested for tensile strength. The test method was the same as in Example 1. The yield strength was of about 36.28 MPa (370 kgf/cm²).

The pellicle membrane was also subjected to an air blow test. The air blow test was identical to that of Example 1. The pellicle of Comparative Example 1 was unproblematic for blowing at 10 mm, but pellicle membrane damage occurred at 9 mm.

**Table 1 - Tensile strength test results**

| | Example 1 | Example 2 | Example 3 | Comparative Example 1 |
|---|---|---|---|---|
| Yield strength (MPa) | 38 23 | 38 25 | 37 76 | 36.28 |
| (kgf/cm²) | (400) | (390) | (385) | (370) |

**Table 2 - Air blow test results**

| Distance between nozzle and membrane (mm) | Example 1 | Example 2 | Example 3 | Comparative Example 1 |
|---|---|---|---|---|
| 10 | No damage | No damage | No damage | No damage |
| 9 | No damage | No damage | No damage | Damage |
| 8 | No damage | No damage | No damage | |
| 7 | No damage | No damage | Damage | |
| 6 | No damage | Damage | | |
| 5 | No damage | | | |
| 4 | Damage | | | |

The present invention allows manufacturing a thin high-strength pellicle and hence affords, a pellicle suitable for the ever higher densities and narrower linewidths encountered in the field of IC technology. The invention makes thus a major contribution to the technical field in question,

## Claims

1. A method for preparing a pellicle for photolithography for use with a light-exposure machine for manufacturing semiconductor devices or liquid crystal display panels, comprising the steps of;
(a) uniformly spreading a solution of a fluorocarbon resin in a solvent over a smooth surface of a flat base plate;
(b) evaporating the solvent from the solution to form a dry film of the resin:
(c) peeling the dry film of the resin off the surface of the base plate; and
(d) heating the dry film before or after adhesive bonding between the dry film and a framework.

2. The method according to claim 1 wherein the heating temperature of the dry film is lower than the glass transition temperature of the fluorocarbon resin.

3. A pellicle for photolithography for use with a light-exposure machine for manufacturing semiconductor devices or liquid crystal display panels with a pellicle membrane having a tensile strength of at least 38,25 MPa.
